(19) Europäisches Patentamt / European Patent Office / Office européen des brevets

(11) **EP 2 607 909 B1**

(12) **FASCICULE DE BREVET EUROPEEN**

(45) Date de publication et mention
de la délivrance du brevet:
**29.08.2018 Bulletin 2018/35**

(51) Int Cl.:
***G01R 27/20*** *(2006.01)*     ***G01R 19/00*** *(2006.01)*
***G06F 17/12*** *(2006.01)*

(21) Numéro de dépôt: **12198012.2**

(22) Date de dépôt: **19.12.2012**

(54) **Pince de terre pour mesurer la résistance de terre d'installations électriques**

Erdklemme zum Messen des Erdungswiderstands von elektrischen Anlagen

Earth clamp for measuring the resistance to earth of electrical facilities

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2011 FR 1162431**

(43) Date de publication de la demande:
**26.06.2013 Bulletin 2013/26**

(73) Titulaire: **CHAUVIN ARNOUX
75018 Paris (FR)**

(72) Inventeur: **Legros, Philippe
75018 Paris (FR)**

(74) Mandataire: **David, Alain et al
Cabinet Beau de Loménie
158, rue de l'Université
75340 Paris Cedex 07 (FR)**

(56) Documents cités:
**EP-A1- 2 249 169    US-B1- 6 396 284**

**Description**

Domaine de l'invention

L'invention concerne la mesure des résistances de terre d'installations électriques au moyen d'un dispositif de contrôle connu sous le vocable de « pince de terre ».

Art antérieur

La mesure de résistances de terre par une pince de terre enserrant le conducteur à mesurer et utilisant deux transformateurs distincts, l'un pour l'injection d'une tension dans la boucle et l'autre pour la mesure du courant en résultant, est bien connue; voir, pour exemple, US6396284 et EP2249169. Une telle mesure qui ne nécessite pas de planter de piquets auxiliaires est particulièrement appropriée lorsque l'installation électrique dispose de multiples mises à la terre en parallèle formant plusieurs boucles de terre successives.

Ainsi, un simple enserrage du conducteur relié à la terre permet de contrôler la qualité du raccordement à la terre par la mesure de l'impédance de la boucle de terre et permet de mesurer la valeur du courant de fuite qui circule de l'installation électrique vers la terre.

Ces courants de fuite plus ou moins importants ne sont pas sans poser des problèmes de sécurité pour les intervenants effectuant l'installation électrique ou son contrôle et venant au contact des équipements connectés au conducteur de protection. En effet, les conducteurs de protection sont souvent non-isolés. En outre, au-delà d'une tension donnée, variable selon les milieux et objet d'une normalisation, la barrière d'isolation que constitue la peau humaine risque de céder provoquant dans le corps humain une augmentation très rapide de la circulation du courant électrique, source de dégâts irrémédiables. C'est pourquoi pour éviter ce risque, il est courant avant toute intervention de pratiquer des tests complémentaires ou une mesure de tension, par exemple au moyen d'un voltmètre ou d'un VAT (vérificateur d'absence de tension), pour s'assurer que la tension au point de contact n'est pas une source de danger pour les intervenants.

Or, l'utilisation de tels moyens complémentaires de contrôle n'est pas toujours aisée dans des installations où l'accès aux conducteurs peut être difficile.

Objet et résumé de l'invention

L'invention a donc pour but de proposer une pince de terre palliant ces inconvénients en permettant d'obtenir cette information sur la tension de contact sans recourir à un équipement de contrôle externe.

Ces buts sont atteints par une pince de terre permettant un contrôle de la tension de contact comportant : un circuit de mesure formé d'un transformateur d'induction de tension comportant un tore sectionné et au moins un enroulement à plusieurs tours m1 et d'un transformateur de mesure de courant comportant un tore sectionné et au moins un enroulement à plusieurs tours m2, adaptés tous deux à être couplés mutuellement par un conducteur de terre dont l'impédance de terre est à mesurer ;et un microcontrôleur pour délivrer une tension alternative à fréquence fixe Fm au dit transformateur d'induction de tension et, en réponse, recevoir des signaux de mesure représentatifs d'une tension de référence $V_{ref}$ générée dans ledit conducteur de terre et d'un courant de terre $i_B + i_F$ (somme d'un courant de boucle $i_B$ et d'un courant de fuites $i_F$) induit dans ledit transformateur de mesure de courant, caractérisé en ce que ledit microcontrôleur est configuré pour extraire par calcul numérique une amplitude E de ladite tension de référence, une amplitude $I_B$ et une amplitude $I_F$ dudit courant de terre et un déphasage $\varphi$ entre ladite tension de référence et ledit courant de boucle $i_B$, et en déduire à ladite fréquence fixe Fm des parts active Rb et réactive Lb de ladite impédance de terre, et pour ensuite calculer ladite impédance de terre à une fréquence déterminée à partir desdites parts active Rb et réactive Lb et en ce que ledit microcontrôleur calcule en outre à ladite fréquence déterminée ladite tension de contact Uc par le produit de ladite impédance de terre par ladite amplitude $I_F$.

Ainsi, en déterminant la tension de contact (le potentiel du point de mesure par rapport à la terre) directement au niveau de la pince de terre sans la mesurer, on peut assurer d'une part une sécurité réelle des personnes bien supérieure à celle offerte par les dispositifs de l'art antérieur n'effectuant qu'une simple mesure d'impédance et d'autre part un retour d'information sur cette tension de contact bien plus aisé et rapide que celui actuel exigeant le recours à un équipement de contrôle complémentaire.

Avantageusement, ladite impédance de terre est calculée à une fréquence d'exploitation Fs et ladite tension de contact Uc est obtenue à ladite fréquence d'exploitation Fs par le produit de ladite impédance de terre par ladite amplitude $I_F$. Une alarme sonore ou visuelle peut alors être générée lorsque ladite tension de contact dépasse un seuil prédéfini qui peut être réglable.

De préférence, lesdites amplitudes E et $I_B$ et ledit déphasage $\varphi$ sont obtenus par une démodulation numérique ou un algorithme de Goertzel et ladite amplitude $I_F$ par un filtrage numérique.

Avantageusement, ladite fréquence d'exploitation est la fréquence du secteur et ladite fréquence fixe est choisie dans la bande passante de fonctionnement desdits deux transformateurs tout en restant éloignée de ladite fréquence du secteur et de ses harmoniques.

De préférence, ledit transformateur d'induction de tension comporte deux enroulements entourant chacun un demi-tore, la commande de ces deux enroulements étant assurée par deux amplificateurs de tension montés en pont et recevant chacun ladite tension alternative à fréquence fixe. Une résistance shunt peut être mise en série entre lesdits deux enroulements pour, par une mesure du courant circulant dans ledit transformateur d'induction de tension, détecter toute ouverture ou défaut de fermeture de ladite pince de terre.

Avantageusement, ledit transformateur d'induction de tension comporte en outre deux autres enroulements entourant chacun un des deux demi-tores et mis en série pour mesurer ladite tension de référence et la délivrer au dit microcontrôleur. Ladite tension de référence est amplifiée et échantillonnée avant sa délivrance au dit microcontrôleur.

De préférence, ledit transformateur de mesure de courant comporte deux enroulements entourant chacun un demi-tore, chacun de ces deux enroulements alimentant un convertisseur courant/tension dont les tensions de sorties sont sommées pour délivrer ledit courant de terre au dit microcontrôleur.

Avantageusement, avant sa délivrance au dit microcontrôleur, ledit courant de terre est filtré, amplifié et échantillonné pour en extraire ledit courant $i_B$.

Brève description des dessins

L'invention sera mieux comprise à la lecture de la description faite ci-après, à titre illustratif mais non limitatif, en référence aux dessins annexés sur lesquels :

- la figure 1 est une vue en perspective d'une pince de terre,
- la figure 2A est une vue d'une ligne électrique et du réseau de terres qui y est associé,
- la figure 2B est une vue d'un bâtiment avec raccords multiples à la terre,
- la figure 3 est un modèle idéal de la partie de mesure de la pince de terre de la figure 1, et
- la figure 4 est un schéma de principe de la pince de terre de la figure 1.

Description détaillée de modes de réalisation

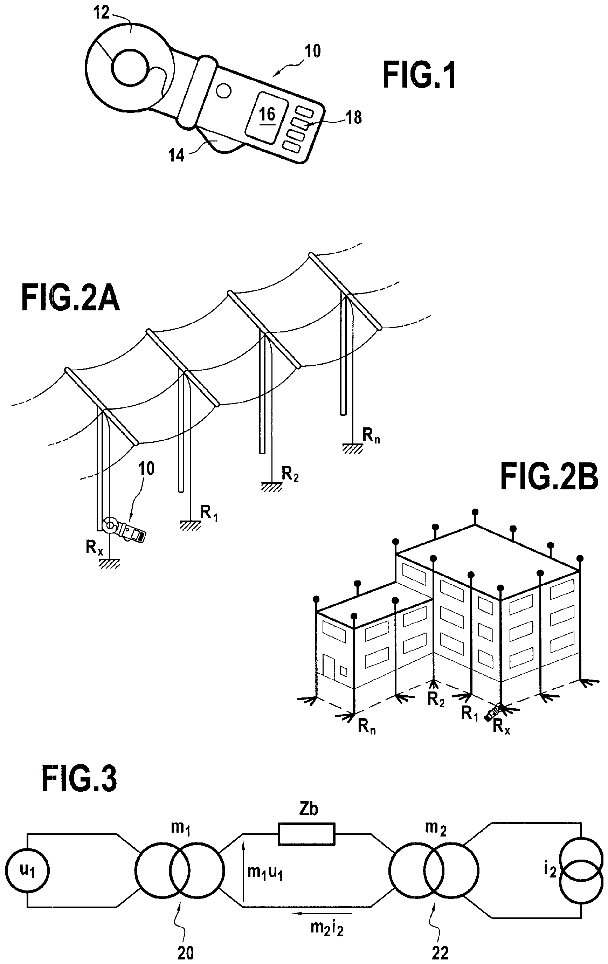

Comme le montre la figure 1, une pince de terre 10 est un dispositif portable qu'un opérateur peut tenir dans une seule main pour contrôler facilement et rapidement le raccordement à la terre d'installations électriques ou de pylônes de lignes électriques comme celles illustrées aux figures 2A et 2B. En effet, au contraire des dispositifs traditionnels, la mesure par pince de terre ne nécessite pas de planter des piquets auxiliaires ou d'ouvrir une liaison à la terre (barrette de terre par exemple) pour isoler l'installation électrique.

La pince de terre comporte une mâchoire 12 qui peut être ouverte au moyen d'une poignée 14 et permet d'enserrer le conducteur relié à la terre et dont on souhaite mesurer l'impédance de terre Zx. La pince de terre comporte en outre un écran de visualisation 16 pour visualiser les paramètres et résultats de la mesure et différents boutons de fonction 18 nécessaires à sa mise en oeuvre.

Le principe de la mesure par pince de terre est illustré schématiquement à la figure 3 qui montre le schéma équivalent idéal (modèle parfait dans lequel la puissance instantanée est conservée et les pertes fer et dans les bobinages ne sont pas pris en compte) de la partie de mesure de la pince de terre qui est formée de l'association d'un transformateur d'injection de tension (ou transformateur de commande 20 à rapport de transformation m1) recevant au primaire une tension alternative U1 à fréquence fixe Fm et d'un transformateur de mesure de courant (transformateur de mesure 22 à rapport de transformation m2) dont le secondaire en court-circuit est parcouru par un courant i2, la boucle de terre d'impédance de boucle Zb constituant à la fois l'enroulement à un tour du secondaire du transformateur d'injection de tension et l'enroulement à un tour du primaire du transformateur de mesure de courant.

L'application des lois de Faraday aux enroulements et du théorème d'Ampère au circuit ainsi constitué par l'association des deux transformateurs et de la boucle de terre à mesurer permet aisément de montrer que l'impédance de boucle Zb est alors donnée par la relation suivante :

$$Zb = (m1/m2)(U1/i2) \text{ ou } Zb = U1/i2 \text{ lorsque } m1 = m2$$

L'amplitude de la tension U1 dépend du rapport de transformation choisi et de l'impédance de boucle à mesurer. Ainsi, par exemple, avec un rapport de transformation de 1/200, une tension U1 de 12V crête permet de générer une tension dite de référence $V_{ref}$ de 60 mV sur la boucle de terre. La fréquence fixe Fm est choisie de façon à être dans la bande passante de fonctionnement des deux transformateurs, tout en étant suffisamment éloignée de la fréquence du secteur et de ses harmoniques, sources de parasites. Ainsi, par exemple, avec une fréquence secteur à 50 ou 60 Hz, des harmoniques à 2160 (harmonique 36 du 60Hz) ou 2200 Hz (harmonique 44 du 50Hz), un choix de Fm à 2181Hz s'avère judicieux car il permet de rejeter ces harmoniques à respectivement 21 et 19Hz de part et d'autre de cette valeur permettant alors aisément un filtrage numérique de i2 à Fm ±10Hz.

Le courant i2 mesuré par le transformateur de mesure de courant 22 est la somme d'un courant de boucle $i_B$ à la fréquence fixe Fm induit par la tension U1 et d'un courant de fuite $i_F$ issu de l'installation électrique, notamment des appareils électriques reliés au secteur, et donc composé d'un signal à large bande comportant cette fréquence secteur et ses harmoniques ainsi éventuellement que d'autres fréquences composites résultant de signaux impulsionnels aléatoires (mise en route d'un moteur par exemple). On notera en outre que les amplitudes de ces deux courants $i_B$ et $i_F$ peuvent être très différentes, par exemple un courant de boucle de 1,2 mA et un courant de fuite de 10A.

On peut aussi montrer que lorsque l'ensemble des boucles de terre forment un réseau étendu de terres comme celui de la figure 2, cette impédance de boucle Zb est composée de l'impédance Zx de la prise de terre enserrée en série avec toutes les autres impédances Z1, Z2, Zn qui en parallèle sont équivalentes à une impédance de faible valeur et dès lors négligeable devant Zx de sorte que l'impédance Zx est sensiblement égale à l'impédance de boucle Zb (qui est dans tous les cas un majorant de Zx) mesurée par la pince de terre.

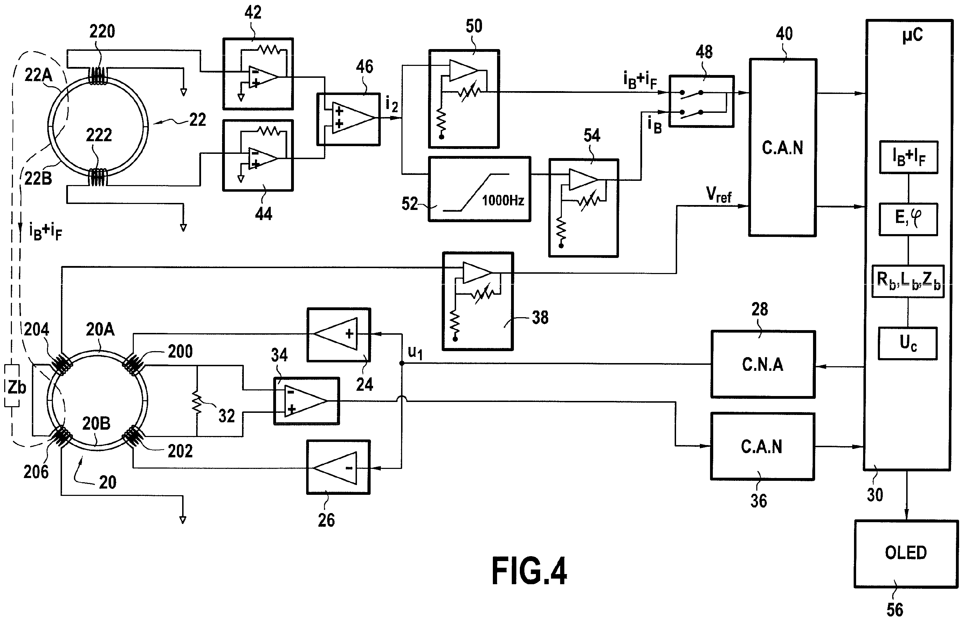

La figure 4 montre le schéma de principe de la pince de terre selon l'invention.

Le transformateur d'induction de tension 20 comporte deux enroulements 200, 202 entourant chacun un demi-tore 20A, 20B, la commande de ces deux enroulements étant assurée par deux amplificateurs de tension 24, 26 montés en pont et recevant chacun la tension alternative U1 à fréquence fixe Fm. Le sectionnement en deux parties du transformateur est indispensable pour permettre l'insertion du conducteur de terre sans avoir à ouvrir la boucle de terre. Par contre, le recours à deux enroulements alimentés par un montage en pont au lieu d'un seul amplifié de façon classique est justifié par le choix d'obtention d'une précision de mesure élevée avec une consommation électrique réduite. La tension alternative U1 provient de la conversion par un convertisseur numérique/analogique 28 d'une tension numérique délivrée par le microcontrôleur 30.

Une résistance shunt 32 est mise en série entre les deux enroulements 200, 202 pour, par une mesure du courant circulant dans le transformateur d'induction de tension 20, détecter toute ouverture ou défaut de fermeture de ladite pince de terre résultant par exemple par la présence de saletés entre les mâchoires de la pince. Cette mesure analogique de courant est amplifiée au travers d'un amplificateur différentiel 34 et convertie en un signal numérique par un convertisseur analogique/numérique 36 pour être envoyée au microcontrôleur 30. Les convertisseurs 28 et 36 sont, par exemple, des convertisseurs 10 ou 12 bits à 1 voie.

Le transformateur d'induction de tension 20 comporte en outre deux autres enroulements 204, 206, appelés enroulements de référence dans la suite de la description, entourant chacun un des deux demi-tores 20A, 20B et mis en série pour mesurer la tension de référence et la délivrer au microcontrôleur 30. La tension de référence est amplifiée par un amplificateur de tension 38 et fait l'objet d'une conversion analogique/numérique par un convertisseur analogique/numérique 40 avant sa délivrance au microcontrôleur 30.

Le transformateur de mesure de courant 22 comporte deux enroulements 220, 222 entourant chacun un demi-tore 22A, 22B, chacun de ces deux enroulements alimentant un convertisseur courant/tension 42, 44 dont les tensions de sorties sont sommées (dans un additionneur 46) pour délivrer le courant de terre i2 qui est ensuite traité dans deux voies d'acquisition parallèles avant sa délivrance au microcontrôleur 30 via un échantillonneur 2 voies 48. La première voie ne filtre pas le signal qui est donc simplement amplifié par un amplificateur à gain variable 50 (gain dépendant de la gamme de mesure) avant de faire l'objet d'une conversion analogique/numérique, le microcontrôleur recevant donc les valeurs échantillonnées de la somme des courants $i_B$ et $i_F$. La seconde voie, au contraire, filtre le signal, par exemple par un filtre passe-haut 52 du second ordre et de fréquence de coupure comprise entre 600 et 1000Hz, puis l'amplifie par un amplificateur à gain variable 54 (gain dépendant aussi de la gamme de mesure) et ensuite également le soumet à une conversion analogique/numérique, le microcontrôleur recevant donc les valeurs échantillonnées du courant de boucle $i_B$ et du courant $i_F$ atténué afin éviter la saturation du convertisseur analogique / numérique 40. La conversion analogique/numérique est avantageusement réalisée dans un même convertisseur analogique/numérique 40 qui est de préférence celui assurant déjà la conversion analogique/numérique de la tension de référence (par exemple un convertisseur 24 bits à 2 voies).

Le microcontrôleur 30 reçoit donc du convertisseur analogique/numérique 40 des valeurs échantillonnées de la tension de référence, du courant $i_B$ et de la somme des courants $i_B$ et $i_F$ à partir desquelles il va pouvoir calculer l'impédance de boucle Zb et bien entendu la tension de contact recherchée Uc. Cette impédance de boucle sera en outre calculée à une quelconque fréquence d'exploitation (même si bien entendu une mesure à la fréquence de mesure reste disponible), c'est-à-dire en général la fréquence du secteur (mais une autre fréquence d'exploitation, à 128Hz par exemple, est aussi envisageable). En effet, chaque boucle est composée d'une part résistive Rb et d'une part inductive Lb. Lorsque la boucle de mesure est grande, cette part inductive peut s'avérer être non négligeable. Or, la part inductive de l'impédance est dépendante de la fréquence de mesure ($Z = L\omega$).

Pour se faire, le microcontrôleur 30 va procéder à une démodulation numérique, connue en soi, de la tension de référence à la fréquence fixe Fm pour obtenir son amplitude E. Cette démodulation numérique met en oeuvre un filtrage numérique passe bas, par exemple à 10Hz, pour éliminer les fréquences parasites. Pareillement, il va procéder à une démodulation numérique semblable à la fréquence fixe Fm du courant $i_B$ pour en extraire l'amplitude $I_B$ et le déphasage $\varphi$ entre la tension de référence et le courant $i_B$, l'amplitude $I_F$ du courant $i_F$ étant obtenue par simple filtrage numérique passe-bas de la somme des courants $i_B$ et $i_F$. La mise en cascade de deux filtres de Tchebychev d'ordre 2 permettent avantageusement d'assurer le filtrage passe-bas de la tension de référence et du courant $i_B$ pour l'obtention de E, $I_B$ et $\delta$ et la mise en cascade de quatre filtres elliptiques d'ordre 4, celle de la somme des courants $i_B$ et $i_F$ pour en extraire l'amplitude $I_F$.

Les mesures de $I_B$ et de $I_F$ sont effectuées successivement ou avantageusement en parallèle, avec un couple de mesure établi au moins 2 fois par seconde (fréquence de rafraîchissement de l'affichage), une mesure en parallèle étant en effet plus précise que deux mesures successives qui supposent une stabilité des deux courants mesurés pendant l'intervalle de mesure.

L'évaluation de l'impédance de boucle conduit avec les dispositifs de mesure de l'art antérieur à une valeur valide à la fréquence de mesure Fm, alors que cette impédance va en réalité être parcourue par des courants de fuites majoritairement de plus basses fréquences (50 ou 60 Hz et proches harmoniques).

Aussi, selon l'invention, l'impédance de boucle Zb repose sur les calculs suivants :

1) Calcul de la part résistive (Rb) et inductive (Lb) de l'impédance de boucle: $Rb = E/I_B \cos(\varphi$ et $Lb = 1/2\pi Fm) E/I_B \sin (\varphi)$

2a) Calcul de l'impédance Zb ramenée à la fréquence de mesure Fm : $Zb = \sqrt{(Rb)^2 + (Lb . 2\pi . Fm)^2}$ ou en variante préférentielle,

2b) Calcul de l'impédance Zb ramenée à la fréquence du secteur Fs : $Zb = \sqrt{(Rb)^2 + (Lb . 2\pi . Fs)^2}$

La tension de contact Uc est ensuite évaluée à partir de l'impédance de boucle Zb et de $I_F$ soit à la fréquence de mesure soit préférentiellement à Fs : $Uc = Zb \, I_F$.

Ainsi, la pince de terre permet de connaître à un instant donné la valeur du courant de fuite ($i_F$), ainsi qu'un majorant de l'impédance de mise à la terre ($Rb \geq Rx$), de sorte qu'il est possible de fournir deux informations de sécurité supplémentaires à l'utilisateur :

1) un majorant de la valeur de la tension de contact au point de mesure,
2) une alarme (visuelle et/ou sonore) en cas de dépassement d'un seuil prédéfini qui peut être variable de la tension de contact.

On notera que d'autres méthodes numériques connues comme un filtrage numérique passe bande ou un algorithme de Goertzel auraient pu être employées en lieu et place de la démodulation numérique pour l'obtention de E et $I_B$ et du déphasage $\varphi$.

**Revendications**

1. Pince de terre (10) permettant un contrôle de la tension de contact, comportant : un circuit de mesure formé d'un transformateur d'induction de tension (20) comportant un tore sectionné (20A, 20B) et au moins un enroulement à plusieurs tours (m1) et d'un transformateur de mesure de courant (22) comportant un tore sectionné (22A, 22B) et au moins un enroulement à plusieurs tours (m2), adaptés tous deux à être couplés mutuellement par un conducteur de terre dont l'impédance de terre est à mesurer ; et un microcontrôleur (30) pour délivrer une tension alternative à fréquence fixe Fm au dit transformateur d'induction de tension et, en réponse, recevoir des signaux de mesure représentatifs d'une tension de référence $V_{ref}$ générée dans ledit conducteur de terre et d'un courant de terre $i_B+i_F$ somme d'un courant de boucle $i_B$ et d'un courant de fuites $i_F$ induit dans ledit transformateur de mesure de courant, **caractérisée en ce que** ledit microcontrôleur est configuré pour extraire par calcul numérique une amplitude E de ladite tension de référence, une amplitude $I_B$ et une amplitude $I_F$ dudit courant de terre et un déphasage $\varphi$ entre ladite tension de référence et ledit courant de boucle $i_B$, et en déduire à ladite fréquence fixe Fm des parts résistive Rb et inductive Lb de ladite impédance de terre, et pour ensuite calculer ladite impédance de terre Zb à une fréquence déterminée à partir desdites parts active Rb et réactive Lb et **en ce que** ledit microcontrôleur calcule en outre à ladite fréquence déterminée ladite tension de contact Uc par le produit de ladite impédance de terre par ladite amplitude $I_F$.

**2.** Pince de terre selon la revendication 1, **caractérisée en ce que** ladite impédance de terre est calculée à une fréquence d'exploitation Fs et ladite tension de contact Uc est obtenue à ladite fréquence d'exploitation Fs par le produit de ladite impédance de terre par ladite amplitude $I_F$.

**3.** Pince de terre selon la revendication 1 ou la revendication 2, **caractérisée en ce qu'**une alarme sonore ou visuelle est générée lorsque ladite tension de contact dépasse un seuil prédéfini qui peut être réglable.

**4.** Pince de terre selon la revendication 1 ou la revendication 2, **caractérisée en ce que** lesdites amplitudes E et $I_B$ et ledit déphasage $\varphi$ sont obtenus par une démodulation numérique ou un algorithme de Goertzel et ladite amplitude $I_F$ par un filtrage numérique.

**5.** Pince de terre selon la revendication 2, **caractérisée en ce que** ladite fréquence d'exploitation est la fréquence du secteur.

**6.** Pince de terre selon la revendication 5, **caractérisée en ce que** ladite fréquence fixe est choisie dans la bande passante de fonctionnement desdits deux transformateurs tout en restant éloignée de ladite fréquence du secteur et de ses harmoniques.

**7.** Pince de terre selon la revendication 1, **caractérisée en ce que** ledit transformateur d'induction de tension comporte deux enroulements (200, 202) entourant chacun un demi-tore, la commande de ces deux enroulements étant assurée par deux amplificateurs de tension (24, 26) montés en pont et recevant chacun ladite tension alternative à fréquence fixe Fm.

**8.** Pince de terre selon la revendication 7, **caractérisée en ce qu'**elle comporte en outre une résistance shunt (32) mise en série entre lesdits deux enroulements pour, par une mesure du courant circulant dans ledit transformateur d'induction de tension, détecter toute ouverture ou défaut de fermeture de ladite pince de terre.

**9.** Pince de terre selon la revendication 1, **caractérisée en ce que** ledit transformateur d'induction de tension comporte en outre deux autres enroulements (204, 206) entourant chacun un des deux demi-tores et mis en série pour mesurer ladite tension de référence et la délivrer au dit microcontrôleur.

**10.** Pince de terre selon la revendication 9, **caractérisée en ce que** ladite tension de référence est amplifiée (38) et échantillonnée (40) avant sa délivrance au dit microcontrôleur.

**11.** Pince de terre selon la revendication 1, **caractérisée en ce que** ledit transformateur de mesure de courant comporte deux enroulements (220, 222) entourant chacun un demi-tore, chacun de ces deux enroulements alimentant un convertisseur courant/tension (42, 44) dont les tensions de sorties sont sommées (46) pour délivrer ledit courant de terre au dit microcontrôleur.

**12.** Pince de terre selon la revendication 9, **caractérisée en ce que**, avant sa délivrance au dit microcontrôleur, ledit courant de terre est filtré (52), amplifié (54) et échantillonné (56) pour en extraire ledit courant $i_B$.

**Patentansprüche**

**1.** Erdungszange (10), die eine Prüfung der Berührungsspannung ermöglicht, umfassend: eine Messschaltung, die von einem Spannungsinduktionstransformator (20), welcher einen unterteilten Kern (20A, 20B) und wenigstens eine Wicklung mit mehreren Windungen (m1) umfasst, sowie von einem Strommesswandler (22), welcher einen unterteilten Kern (22A, 22B) und wenigstens eine Wicklung mit mehreren Windungen (m2) umfasst, gebildet ist, die beide dazu ausgelegt sind, durch eine Erdungsleitung, deren Erdungsimpedanz zu messen ist, gegenseitig gekoppelt zu werden; und einen Mikrocontroller (30), um dem Spannungsinduktionstransformator eine Wechselspannung mit fester Frequenz Fm zu liefern und als Reaktion Messsignale zu empfangen, die für eine in der Erdungsleitung erzeugte Referenzspannung $V_{ref}$ und für einen Erdstrom $i_B+i_F$, Summe aus einem Schleifenstrom $i_B$ und einem Streustrom $i_F$, der in dem Strommesswandler induziert wird, repräsentativ sind, **dadurch gekennzeichnet, dass** der Mikrocontroller dazu ausgelegt ist, durch numerische Berechnung eine Amplitude E der Referenzspannung, eine Amplitude $I_B$ und eine Amplitude $I_F$ des Erdstroms und eine Phasenverschiebung $\varphi$ zwischen der Referenzspannung und dem Schleifenstrom $i_B$ zu gewinnen und hieraus bei der festen Frequenz Fm einen resistiven Anteil Rb und einen induktiven Anteil Lb der Erdungsimpedanz abzuleiten und um anschließend die Erdungsimpedanz Zb bei einer bestimmten Frequenz aus dem aktiven Anteil Rb und dem reaktiven Anteil Lb zu berechnen, und dass der Mikrocontroller ferner bei der bestimmten Frequenz die Berührungsspannung Uc durch das Produkt aus der Erdungsimpedanz mal der Amplitude $I_F$ berechnet.

2. Erdungszange nach Anspruch 1, **dadurch gekennzeichnet, dass** die Erdungsimpedanz bei einer Betriebsfrequenz Fs berechnet wird und die Berührungsspannung Uc bei der Betriebsfrequenz Fs durch das Produkt aus der Erdungsimpedanz mal der Amplitude $I_F$ erhalten wird.

3. Erdungszange nach Anspruch 1 oder Anspruch 2, **dadurch gekennzeichnet, dass** ein akustischer oder visueller Alarm erzeugt wird, wenn die Berührungsspannung einen vordefinierten Schwellwert, der einstellbar sein kann, übersteigt.

4. Erdungszange nach Anspruch 1 oder Anspruch 2, **dadurch gekennzeichnet, dass** die Amplituden E und $I_B$ und die Phasenverschiebung $\varphi$ durch eine digitale Demodulation oder einen Goertzel-Algorithmus und die Amplitude $I_F$ durch eine digitale Filterung erhalten werden.

5. Erdungszange nach Anspruch 2, **dadurch gekennzeichnet, dass** die Betriebsfrequenz die Netzfrequenz ist.

6. Erdungszange nach Anspruch 5, **dadurch gekennzeichnet, dass** die feste Frequenz aus dem Betriebsdurchlassband der beiden Transformatoren ausgewählt ist und dabei von der Netzfrequenz und deren Oberschwingungen entfernt bleibt.

7. Erdungszange nach Anspruch 1, **dadurch gekennzeichnet, dass** der Spannungsinduktionstransformator zwei Wicklungen (200, 202) umfasst, die jeweils einen halben Kern umgeben, wobei die Steuerung dieser beiden Wicklungen durch zwei Spannungsverstärker (24, 26), die als Brücke geschaltet sind und jeweils die Wechselspannung mit fester Frequenz Fm erhalten, sichergestellt ist.

8. Erdungszange nach Anspruch 7, **dadurch gekennzeichnet, dass** sie ferner einen Shunt-Widerstand (32) umfasst, der zwischen den beiden Wicklungen in Reihe geschaltet ist, um durch eine Messung des in dem Spannungsinduktionstransformator fließenden Stroms jedwedes Öffnen oder jedweden Schließfehler der Erdungszange zu erfassen.

9. Erdungszange nach Anspruch 1, **dadurch gekennzeichnet, dass** der Spannungsinduktionstransformator ferner zwei weitere Wicklungen (204, 206) umfasst, die jeweils einen der beiden halben Kerne umgeben und in Reihe geschaltet sind, um die Referenzspannung zu messen und sie an den Mikrocontroller zu liefern.

10. Erdungszange nach Anspruch 9, **dadurch gekennzeichnet, dass** die Referenzspannung verstärkt (38) und abgetastet (40) wird, bevor sie an den Mikrocontroller geliefert wird.

11. Erdungszange nach Anspruch 1, **dadurch gekennzeichnet, dass** der Strommesswandler zwei Wicklungen (220, 222) aufweist, die jeweils einen halben Kern umgeben, wobei eine jede dieser beiden Wicklungen einen Strom-Spannungs-Wandler (42, 44) speist, dessen Ausgangsspannungen summiert (46) werden, um den Erdstrom an den Mikrocontroller zu liefern.

12. Erdungszange nach Anspruch 9, **dadurch gekennzeichnet, dass** der Erdstrom vor seiner Lieferung an den Mikrocontroller gefiltert (52), verstärkt (54) und abgetastet (56) wird, um hieraus den Strom $i_B$ zu gewinnen.

**Claims**

1. An earth clamp (10) allowing the testing of contact voltage, comprising: a measurement circuit formed of a voltage inducing transformer (20) comprising a split core (20A, 20B) and at least one winding with several turns (m1) and a current measuring transformer (22) comprising a split core (22A, 22B) and at least one winding with several turns (m2), both adapted to be mutually coupled by an earth conductor whose earth impedance is to be measured; and a microcontroller (30) to deliver an alternating voltage at fixed frequency Fm to said voltage inducing transformer and, in response, to receive measurement signals representing a reference voltage $V_{ref}$ generated in said earth conductor and an earth current $i_B+i_F$ sum of a loop current $i_B$ and of a leakage current $i_F$ induced in said current measuring transformer, **characterized in that** said microcontroller is configured to extract by numerical computation an amplitude E of said reference voltage, an amplitude $I_B$ and an amplitude $I_F$ of said earth current and a phase shift $\varphi$ between said reference voltage and said loop current $i_B$, and to deduce therefrom resistive Rb and inductive Lb parts of said earth impedance at said fixed frequency Fm, and then to calculate said earth impedance Zb at a determined frequency using said active Rb and reactive Lb parts, and **in that** said microcontroller further computes said contact voltage Uc at said determined frequency from the product of said earth impedance times said amplitude $I_F$.

2. The earth clamp according to claim 1, **characterized in that** said earth impedance is calculated at an operating frequency Fs and said contact voltage Uc is obtained at said operating frequency Fs by the product of said earth impedance times said amplitude $I_F$.

3. The earth clamp according to claim 1 or claim 2, **characterized in that** a sound or visual alarm is generated when said contact voltage exceeds a predefined threshold which can be adjustable.

4. The earth clamp according to claim 1 or claim 2, **characterized in that** said amplitudes E and $I_B$ and said phase shift $\varphi$ are obtained by digital demodulation or a Goertzel algorithm and said amplitude $I_F$ by digital filtering.

5. The earth clamp according to claim 2, **characterized in that** said operating frequency is the mains power supply frequency.

6. The earth clamp according to claim 5, **characterized in that** said fixed frequency is chosen in the operating bandwidth of said two transformers whilst remaining distant from said mains power supply frequency and its harmonics.

7. The earth clamp according to claim 1, **characterized in that** said voltage inducing transformer comprises two windings (200, 202) each surrounding a semi-core, the controlling of these two windings being ensured by two voltage amplifiers (24, 26) bridge-mounted and each receiving said alternating voltage at fixed frequency Fm.

8. The earth clamp according to claim 7, **characterized in that** it further comprises a shunt resistance (32) placed in series between said two windings so that, by measuring the current circulating in said voltage inducing transformer, it can detect any opening or faulty closing of said earth clamp.

9. The earth clamp according to claim 1, **characterized in that** said voltage inducing transformer further comprises two other windings (204, 206) each surrounding one of the two semi-cores and placed in series to measure said reference voltage and to deliver the same to said microcontroller.

10. The earth clamp according to claim 9, **characterized in that** said reference voltage is amplified (38) and sampled (40) before being delivered to said microcontroller.

11. The earth clamp according to claim 1, **characterized in that** said current measuring transformer comprises two windings (220, 222) each surrounding a semi-core, each of these two windings supplying a current/voltage converter (42, 44) whose output voltages are summed (46) to deliver said earth current to said microcontroller.

12. The earth clamp according to claim 9, **characterized in that**, before being delivered to said microcontroller, said earth current is filtered (52), amplified (54) and sampled (56) to extract therefrom said current $i_B$.

**FIG.1**

**FIG.2A**

**FIG.2B**

**FIG.3**

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6396284 B

- EP 2249169 A